# EUROPÄISCHE PATENTSCHRIFT

(11) **EP 2 422 381 B1**
(45) Veröffentlichungstag und Bekanntmachung des Hinweises auf die Patenterteilung: **30.10.2019**
(21) Anmeldenummer: 10715233.2
(22) Anmeldetag: 22.04.2010
(51) Int. Cl.: H01L 51/50

(54) **STRAHLUNGSEMITTIERENDE VORRICHTUNG**
RADIATION-EMITTING DEVICE
DISPOSITIF ÉMETTEUR DE RAYONNEMENT

(30) Priorität: 23.04.2009 DE 102009018647
(43) Veröffentlichungstag der Anmeldung: 29.02.2012
(73) Patentinhaber: OSRAM OLED GmbH, 93049 Regensburg (DE)
(72) Erfinder: HUNZE, Arvid, 66271 Kleinblittersdorf (DE); CHIU, Chien-Shu, 106, Taipei City DA´An District (TW); KRAUSE, Ralf, 91058 Erlangen (DE)
(74) Vertreter: Epping - Hermann - Fischer
(86) Internationale Anmeldenummer: PCT/EP2010/055368
(87) Internationale Veröffentlichungsnummer: WO 2010/122113

(56) Entgegenhaltungen:
- WO-A2-2005/029606
- US-A1- 2003 178 619
- US-A1- 2005 196 638
- CHENG GANG ET AL: "Improved efficiency for white organic light-emitting devices based on phosphor sensitized fluorescence" APPLIED PHYSICS LETTERS, AIP, AMERICAN INSTITUTE OF PHYSICS, MELVILLE, NY, US LNKD- DOI:10.1063/1.2178478, Bd. 88, Nr. 8, 24. Februar 2006 (2006-02-24), Seiten 83512-083512, XP012083026 ISSN: 0003-6951
- HOLMES R ET AL: "Saturated deep blue organic electrophosphorescence using a fluorine-free emitter" APPLIED PHYSICS LETTERS, AIP, AMERICAN INSTITUTE OF PHYSICS, MELVILLE, NY, US LNKD- DOI:10.1063/1.2143128, Bd. 87, Nr. 24, 7. Dezember 2005 (2005-12-07), Seiten 243507-243507, XP012076904 ISSN: 0003-6951

## Beschreibung

Die vorliegende Erfindung betrifft eine strahlungsemittierende Vorrichtung mit einer Emitterschicht, die ein Matrixmaterial, einen strahlungsemittierenden fluoreszierenden Emitter und einen Exzitonenfänger enthält. Diese Patentanmeldung beansprucht die Priorität der deutschen Patentanmeldung 10 2009 018 6476.

Hoch effiziente Emitter mit möglichst langer Lebensdauer sind eine der Voraussetzungen für die Entwicklung hoch effizienter organischer lichtemittierender Dioden (OLEDs) sowie für Display- und Lightinganwendungen. Entscheidend für eine hohe Effizienz ist die Quanteneffizienz des einzelnen Emittermoleküls und die Quanteneffizienz des Emittersystems (aus Matrix und strahlungsemittierendem Emitter) insgesamt. Hohe Lebensdauern können aber nicht für alle emittierten Farben in gleichem Maß realisiert werden. Emitterschichten, die im violetten oder blauen Spektralbereich Licht emittieren, weisen deutlich kürzere Lebensdauern auf, als Emitterschichten die im grünen, gelben, orangen oder roten Spektralbereich emittieren. Dies gilt insbesondere für phosphoreszente Emitter. Eine OLED mit einem blauen fluoreszierendem Emitter wird in der WO 2005/029606 A2 beschrieben.

Aufgabe der Erfindung ist es, eine strahlungsemittierende Vorrichtung bereitzustellen, die eine im violetten oder blauen Spektralbereich Licht emittierende Emitterschicht verbesserter Quanteneffizienz und erhöhter Lebensdauer aufweist.

Diese Aufgabe wird durch die Vorrichtung gemäß dem unabhängigen Anspruch 1 gelöst. Weitere Ausgestaltungen sind Gegenstand von Unteransprüchen.

Die erfindungsgemäße strahlungsemittierende Vorrichtung umfasst ein Substrat, eine erste Elektrode und eine zweite Elektrode sowie eine zwischen der ersten und der zweiten Elektrode angeordnete Emitterschicht, die (im Betrieb) Licht im violetten und/oder blauen Spektralbereich emittiert. Diese Emitterschicht enthält zum einem 0,1 bis 5 Gew.-% eines fluoreszierenden strahlungsemittierenden Emitters (der im violetten oder blauen Spektralbereich emittiert) und 1 bis 30 Gew.-% eines phosphoreszenten Exzitonenfängers. Neben dem fluoreszierenden strahlungsemittierenden Emitter und dem phosphoreszenten Exzitonenfänger weist die Emitterschicht ein Matrixmaterial auf (auf das sich die Angaben in Gew.-% beziehen). Im Regelfall ist der Gewichtsanteil des Exzitonenfängers größer als der des fluoreszierenden Emitters. Das Emissionsmaximum des fluoreszierenden Emitters liegt im blauen oder violetten Spektralbereich, das des phosphoreszenten Exzitonenfängers im blauen, violetten oder ultravioletten Spektralbereich.

Durch die erfindungsgemäße Emitterschicht, die neben dem Matrixmaterial und dem fluoreszierenden Emitter auch einen phosphoreszenten Exzitonenfänger umfasst, ist es möglich, die Quanteneffizienz und die Leistungseffizienz zu verbessern. Im Regelfall bewirkt die Anwesenheit des phosphoreszenten Exzitonenfängers und des fluoreszierenden Emitters auch ein besseres Ladungsträgergleichgewicht und eine geringere Spannung - also eine verbesserte Stromeffizienz.

Im Folgenden werden die einzelnen Komponenten der strahlungsemittierenden Vorrichtung der vorliegenden Erfindung näher erläutert:
Ein "Substrat" umfasst gemäß der vorliegenden Erfindung zum Beispiel ein Substrat, wie es im Stand der Technik herkömmlich für eine strahlungsemittierende Vorrichtung verwendet wird. Beispielsweise kann das Substrat Glas, Quarz, Kunststofffolien, Metall, Metallfolien, Siliziumwafer oder ein anderes geeignetes Substratmaterial umfassen. Ist die strahlungsemittierende Vorrichtung zum Beispiel als so genannter "Bottom-Emitter" ausgeführt, ist das Substrat vorzugsweise transparent und beispielsweise als Glassubstrat ausgeführt. In der erfindungsgemäßen strahlungsemittierenden Vorrichtung kann die erste Elektrode auf dem Substrat abgeschieden sein.

Die "erste Elektrode", wie sie hierin verwendet wird, kann zum einen eine Anode sein. Die Anode kann aus einem löcherinjizierenden Material bestehen. Als löcherinjizierendes Material kann jedes im Stand der Technik bekannte, löcherinjizierende Material verwendet werden. Ist die strahlungsemittierende Vorrichtung beispielsweise als "Bottom-Emitter" ausgebildet, so besteht die Anode üblicherweise aus einem transparenten Material. Beispielsweise kann sie aus transparenten leitenden Oxiden bestehen oder eine Schicht hieraus umfassen. Diese transparenten leitenden Oxide (transparent conductive oxides, "TCO") schließen Metalloxide, wie beispielsweise Zinkoxid, Zinnoxid, Cadmiumoxid, Titanoxid, Indiumoxid oder Indiumzinnoxid (ITO), Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide ein, sind jedoch nicht auf diese beschränkt. Die TCOs unterliegen dabei nicht zwingend einer stöchometrischen Zusammensetzung und können ferner auch p- oder n-dotiert sein.

Wenn die erste Elektrode eine Anode ist, ist die zweite Elektrode eine Kathode. Die "Kathode" kann aus einem elektroneninjizierenden Material bestehen. Als Kathodenmaterialien können dabei im Stand der Technik übliche Kathodenmaterialien, insbesondere Aluminium, Barium, Indium, Silber, Gold, Magnesium, Calcium oder Lithium sowie Verbindungen, und Legierungen dieser Stoffe und Gemische der vorgenannten Elemente, Verbindungen und/oder Legierungen verwendet werden. Alternativ oder zusätzlich können auch eines oder mehrere der bei den Anoden-Materialien genannten TCOs enthalten sein bzw. kann die Kathode auch vollständig aus einem dieser Materialien bestehen. Die Kathode kann damit auch transparent ausgeführt sein.

In der strahlungsemittierenden Vorrichtung kann zum Beispiel eine Elektrode transparent und die andere reflektierend ausgeführt sein. Die strahlungsemittierende Vorrichtung kann somit entweder als "Bottom-Emitter" oder als "Top-Emitter" ausgeführt werden. Alternativ dazu können auch beide Elektroden transparent ausgeführt sein.

Die Emitterschicht der erfindungsgemäßen strahlungsemittierenden Vorrichtung bezeichnet eine funktionelle Schicht aus einem Matrixmaterial, das einen oder mehrere fluoreszierende Emitter und einen oder mehrere phosphoreszente Exzitonenfänger enthält beziehungsweise aus dem Matrixmaterial, dem mindestens einen Emitter und dem mindestens einen Exzitonenfänger besteht.

Bei dem phosphoreszenten Exzitonenfänger handelt es sich um eine Verbindung, auf die ein effizienter Energieübertrag vom Matrixmaterial möglich ist. Dem Exzitonenfänger kommt dann die Aufgabe zu, einen effizienten und schnellen Energieübertrag auf das Emittermaterial zu gewährleisten, d.h. Exzitonen auf dieses Emittermaterial zu übertragen. Obwohl der Exzitonenfänger eine phosphoreszente Verbindung ist, kommt es insbesondere nicht darauf an, dass der Exzitonenfänger Strahlung emittiert; vielmehr ist es wesentlich, dass der Exzitonenfänger einen guten Transport der Exzitonen (und möglichst auch der Ladungsträger) gewährleistet. Die als Exzitonenfänger verwendeten Materialien unterscheiden sich stets von den als Emitter eingesetzten Materialien.

Erfindungsgemäß wurde beobachtet, dass auf den Matrixmolekülen (oder Exzitonenfängern) Exzitonen gebildet werden und die auf den Matrixmolekülen gebildeten Triplett-Exzitonen von den Exzitonenfängern "eingefangen" werden; die Exzitonen werden anschließend zum (Singulettzustand der) fluoreszierenden Emitter transferiert. Hierdurch können zumindest teilweise die Triplettexzitonen des phosphoreszenten Exzitonenfängers auf dem fluoreszierenden Emitter strahlend genutzt werden, ohne dass diese auf dem phosphoreszenten Emitter strahlend oder nicht strahlend rekombinieren. Erfindungsgemäß wurde also erkannt, dass sich mit der erfindungsgemäßen Emitterschicht die hohe Effizienz des phosphoreszenten (zum Beispiel im Blauen emittierenden) Exzitonenfängers mit der guten Langzeitstabilität des fluoreszierenden (insbesondere blauen) Emitters kombiniert werden können. Nach dem Stand der Technik werden dagegen entweder Emitterschichten mit phosphoreszenten Emittern verwendet, bei denen zwar eine hohe Quanteneffizienz zu verzeichnen ist, da auch die Triplettexzitonen strahlend rekombinieren können, die aber (im Fall der blauen Emitter) eine geringe Langzeitstabilität besitzen; andererseits werden Emitterschichten mit blau fluoreszierenden Emittern eingesetzt, die eine wesentlich höhere Langzeitstabilität besitzen als phosphoreszierende blaue Emitter, die aber eine deutliche geringere Quanteneffizienz aufweisen, da nur Singulettexzitonen auf diesen Emittermaterialien strahlend rekombinieren können.

Bei der diesem Exzitonentransfer zugrunde liegenden Transferkaskade wird also ein auf den Matrixmaterial oder dem phosphoreszenten Exzitonenfänger generiertes Triplettexziton letztendlich auf den Singulettzustand des fluoreszierenden Emitters übertragen. Dies ist insbesondere aufgrund der Tatsache möglich, dass aufgrund der Spinn-Bahn-Kopplung Exzitonen generell eine Mischung aus Triplett- und SingulettZustand darstellen. Erfindungsgemäß eignen sich insbesondere "Triplett-Exzitonen" mit einer Zerfallszeit < 10 µs für einen Transfer auf das Singulettniveau des fluoreszierenden Emitters.

Durch die höhere Konzentration des Exzitonenfänger wird ein effizienter Energieübertrag auf die fluoreszierenden Emitter gewährleistet. Durch die niedrigere Konzentration des Emitters kann dagegen verhindert werden, dass, insbesondere bei Emittern ohne sterische Hinderung, eine Stapelung der Moleküle auftritt, welche eine Rotverschiebung des emittierten Spektrums zur Folge haben kann. Die hohen Konzentrationen des Exzitonenfängers bewirken dagegen - neben den vorstehenden Effekten, dass diese Exzitonenfänger nicht als Fallenzentren für die Ladungsträger wirken; im Gegenteil, es kann ein guter Transport der Ladungsträger stattfinden.

Insbesondere kann ein Ladungsträgertransport erfolgen, indem die Matrix die Majoritätsladungsträger transportiert und der Exzitonenfänger die Minoritätsladungsträger mit entgegengesetzter Ladung (z. B. werden bei einer lochtransportierenden Matrix die Elektronen über das LUMO des Exzitonenfängers transportiert). Die erfindungsgemäße strahlungsemittierende Vorrichtung weist daher im Regelfall auch eine verbesserte Stromeffizienz auf. Oft ist die Stromeffizienz (verglichen mit Emitterschichten ohne Exzitonenfänger) auf um mindestens 10% erhöht. Häufig liegt die Stromeffizienz sogar 20% und vielfach sogar 25% über der Stromeffizienz einer entsprechenden Emitterschicht ohne den erfindungsgemäßen Exzitonenfänger. Dies gilt insbesondere für Stromeffizienzen bei hohen Lichtstärken, d.h. Lichtstärken, die typischerweise größer 1000 cd/m² sind.

Zusammenfassend kann festgestellt werden, dass erfindungsgemäß erkannt wurde, dass durch die Kombination eines phosphoreszenten Exzitonenfängers in hoher Konzentration und eines Emittermaterials in niedrigerer Konzentration unabhängig voneinander zwei Effekte realisiert werden können. Zum einen werden durch dieses gemischte System im Betrieb zunächst Exzitonen vom Matrixmaterial auf den Exzitonenfänger übertragen beziehungsweise auf dem Exzitonenfänger gebildet. Durch einen effizienten und schnellen Energieübertrag werden dann die Triplett-Exzitonen auf das Singulett-Niveau des fluoreszierenden Emitters (mit gegenüber dem phosphoreszenten Exitonenfänger erhöhter Lebensdauer) übertragen, auf dem strahlend zerfallen können. Außerdem weist der Exzitonenfänger hervorragende Leitungseigenschaften für die Minoritätsladungsträger auf. Beide Effekte führen insgesamt zu einer deutlich erhöhten Quanteneffizienz und daneben auch zu einem besseren Ladungsträgergleichgewicht und zu einer geringeren Spannung.

Der fluoreszierende Emitter und der Exzitonenfänger können jeweils in ein Matrixmaterial eingebettet sein, das beispielsweise ausgewählt ist aus der Gruppe, bestehend aus mCP (1,3-Bis(carbazol-9-yl)benzol), TCP (1,3,5-Tris(carbazol)-9-yl)benzol), TCTA (4,4',4''-Tris(carbazol-9-yl)triphenylamin), TPBi (1,3,5-tris(1-phenyl-1-H-benzimidazol-2-yl)benzol), CBP (4,4'-Bis(carbazol-9-yl)biphenyl), CDBP (4,4'-Bis(9-carbazolyl)-2,2'-dimethylbiphenyl), (DMFL-CBP 4,4'-Bis(carbazol-9-yl)-9,9-dimethylfluoren), FL-4CBP (4,4'-Bis(carbazol-9-yl)-9,9-bis(9-phenyl-9H-carbazol)fluoren), FL-2CBP (9,9-Bis(4-carbazol-9-yl)-phenyl)fluoren, auch abgekürzt als CPF), DPFL-CBP (4,4'-Bis(carbazol-9-yl)-9,9-ditolylfluoren), FL-2CBP (9,9-Bis(9-phenyl-9H-carbazol)fluoren), Spiro-CBP (2,2',7,7'-Tetrakis(carbazol-9-yl)-9,9'-spiro-bifluoren), ADN (9,10-Di(naphth-2-yl)anthracen, TBADN (3-Tert-butyl-9,10-di(naphth-2-yl)anthracen, DPVBi (4,4'-Bis(2,2-diphenyl-ethen-1-yl)-4,4'-dimethylphenyl), p-DMDPVBi (4,4'-Bis(2,2-diphenyl-ethen-1-yl)-4,4'-dimethylphenyl), TDAF (Tert(9,9-diarylfluoren)), BSBF (2-(9,9'-Spirobifluoren-2-yl)-9,9'-spirobifluoren), TSBF (2,7-Bis(9,9'-spirobifluoren-2-yl)-9,9'-spirobifluoren), BDAF Bis(9,9-diarylfluoren), p-TDPVBi (4,4'-Bis(2,2-diphenylethen-1-yl)-4,4'-di-(tert-butyl)phenyl), TPB3 (1,3,5-Tri-(pyren-1-yl)benzol), PBD (2-(4-Biphenylyl)-5-(4-tert-butylphenyl)-1,3,4-oxadiazol), BCP (2,9-Dimethyl-4,7-diphenyl-1,10-phenanthrolin), BP-OXD-Bpy (6,6'-Bis[5-(biphenyl-4-yl)-1,3,4-oxadiazo-2-yl]-2,2'-bipyridyl), NTAZ (4-(Naphth-1-yl)-3,5-diphenyl-4H-1,2,4-triazol), Bpy-OXD (1,3-Bis[2-(2,2'-bipyrid-6-yl)-1,3,4-oxadiazo-5-yl]benzol), BPhen (4,7-Diphenyl-1,10-phenanthrolin), TAZ (3-(4-Biphenylyl)-4-phenyl-5-tert-butylphenyl-1,2,4-triazol), PADN (2-phenyl-9,10-di(naphth-2-yl)-anthracen), Bpy-FOXD (2,7-Bis[2-(2,2'-bipyrid-6-yl)-1,3,4-oxadiazol-5-yl]-9,9-dimethylfluoren), OXD-7 (1,3-Bis[2-(4-tert-butylphenyl)-1,3,4-oxadiazol-5-yl]benzol), HNBphen (2-(naphth-2-yl)-4,7-diphenyl-1,10-phenanthrolin), NBphen (2,9-Bis(naphth-2-yl)-4,7-diphenyl-1,10-phenanthrolin), 3TPYMB (Tris(2,4,6-trimethyl-3-(pyrid-3-yl)phenyl)boran), 2-NPIP (1-methyl-2-(4-(naphth-2-yl)phenyl)-1H-imidazo[4,5-f] [1,10]phenanthrolin), Liq (8-Hydroxychinolinolato-lithium) und Alq (Bis(2-methyl-8-chinolinolat)-4-(phenylphenolato)aluminium) sowie aus Gemischen der vorgenannten Stoffe. Als Matrixmaterial bevorzugt sind aromatische Materialien mit hohem Stickstoffanteil, etwa die Materialen mCP, TCTA, TPBi, BCP, BPhen, CBP, CDBP und CPF (d.h. FL-2CBP) oder Metallkomplexe, etwa Alq. Bei der Verwendung von Metallkomplexen als Matrixmaterial, dürfen diese nicht mit dem Emittermaterial (oder dem Exzitonenfänger) übereinstimmen. Als Matrixmaterialien die in gemischten System vorliegen, eignen sich beispielsweise Mischungen aus einem oder mehreren der Materialien TCTA, mCP, CBP, CDBP oder CPF untereinander oder Mischungen mit TPBi verwendet.

Ein blau phosphoreszierender Exzitonenfänger kann ausgewählt sein aus der Gruppe, bestehend aus FIrPic (Bis(3,5-difluoro-2-(2-pyridyl)phenyl-(2-carboxypyridyl)-iridium III), FIr6 (Bis(48,68-difluorophenylpyridinato)-tetrakis (1-pyrazolyl)borat-iridium III), *mer*-Ir(dpbic)₃ (*mer-*Iridium(III) tris(1,3-diphenyl-benzimidazolin-2-yliden-C,C2')), *mer*-Ir(cn-pmic)₃ (*mer*-Iridium(III) tris(1-methyl-3-p-cyanophenyl-imidazolin-2-yliden-C,C2')), *mer*-Rh(cn-pmic)₃ (*mer*-Rhodium(III) tris(1-methyl-3-p-cyanophenyl-imidazolin-2-yliden-C,C2')), Pt(cn-pmic)acac (Platin(II) (1-methyl-3-p-cyanophenyl-imidazolin-2-yliden-C,C2')acetylacetonat) sowie aus Gemischen der vorgenannten Stoffe. Die vier zuletzt genannten Stoffe sind in P. Erk et al. SID06 Digest 2006,131-134 und der dort zitierten Literatur offenbart. Die genannten Emittermaterialien haben ihr Emissionsmaximum im blauen Spektralbereich. Weist generell ein Exzitonenfänger oder ein Emitter mehrere Emissionsmaxima auf, so gilt als Emissionsmaximum im Sinne dieser Erfindung das Emissionsmaximum mit der größten Intensität. Existieren bei unterschiedlichen Stromstärken zwei oder mehr intensitätsstärkste Emissionsmaxima bei unterschiedlichen Wellenlängen, so gilt von diesen Emissionsmaxima im Sinne dieser Erfindung das Maximum bei der kleineren Wellenlänge als Emissionsmaximum (insbesondere für die Bestimmung der Differenz der Wellenlängen des Emissionsmaximums des strahlungsemittierenden Emitters und des Emissionsmaximums des Exzitonenfängers).

Ein blau phosphoreszierender Exzitonenfänger kann ausgewählt sein aus der Gruppe, bestehend aus *fac*-Ir(Pmb)₃ (*fac-*Iridium(III) tris(1-phenyl-3-methylbenzimidazolin-2-yliden-C,C2')), *mer*-Ir(Pmb)₃ (*mer*-Iridium(III) tris(1-phenyl-3-methylbenzimidazolin-2-yliden-C,C2')), *fac*-Ir(dpbic)₃ (*fac-*Iridium(III) tris(1,3-diphenyl-benzimidazolin-2-yliden-C,C2') - P. Erk et al. SID06 Digest 2006,131-134) sowie aus Gemischen der vorgenannten Stoffe. Exzitonenfänger, die das Emissionsmaximum im violetten oder ultravioletten Spektralbereich das Emissionsmaximum aufweisen sind ferner in C. Schildknecht et al. "Organic Light Emitting Materials and Devices XI." Edited by Kafafi, Zakya H.; So, Franky. Proceedings of SPIE, Volume 6655, pp. 665502 (2007) (SPIE = The International Society for Optical Engineering) offenbart. Das Emissionsmaximum derartiger Exzitonenfängers liegt dabei üblicherweise bei einer Wellenlänge von zumindest 390 nm.

Als fluoreszierender Emitter kann eine Verbindung eingesetzt werden, die das Emissionsmaximum im violetten oder blauen Spektralbereich aufweist. Das Emissionsspektrum des Emitters kann weitere Maxima aufweisen; im Regelfall werden diese aber auch im blauen und/oder violetten Spektralbereich liegen. Als blau fluoreszierender Emitter kann beispielsweise eine Verbindung eingesetzt werden die ausgewählt ist aus der Gruppe, bestehend aus BCzVBi (4,4'-Bis(9-ethyl-3-carbazovinylen)-1,1'-biphenyl), Perylen, TBPe (2,5,8,11-Tetra-tert-butylperylen), BCzVB (9H-Carbazol-3,3'-(1,4-phenylen-di-2,1-ethendiyl)bis[9-ethyl-(9C)]), DPAVBi 4,4-Bis[4-(di-p-tolylamino)styryl]biphenyl, DPAVB (4-(Di-p-tolylamino)-4'-[(di-p-tolylamino)styryl]stilben), BDAVBi (4,4'-Bis[4-(diphenylamino)styryl]biphenyl), BNP3FL (N,N'-Bis(naphthalen-2-yl)-N,N'-bis (phenyl)-tris-(9,9-dimethylfluorenylen), 9,10-Bis[(9-ethyl-3-carbazoyl)-vinylenyl]-anthracen, 4,4'-Bis(diphenylvinylenyl)-biphenyl, 1,4-Bis(9-ethyl-3-carbazovinylen)-2-methoxy-5-(2-thylhexyloxy)benzol, 4,4'-Bis(diphenylvinylenyl)-anthracen, 1,4-Bis(9-ethyl-3-carbazovinylen)-9,9-dihexyl-fluoren sowie aus Gemischen der vorgenannten Stoffe. Die genannten Emittermaterialien haben ihr Emissionsmaximum im blauen Spektralbereich.

In einer nicht erfinderischen Ausführungsform ist die Emitterschicht in mindestens zwei Teilschichten unterteilt. Sie weist dabei zumindest eine erste Teilschicht (d. h. Teilschicht(en) eines ersten Typs) auf, bei der das Matrixmaterial nur den fluoreszierenden strahlungsemittierenden Emitter aber keinen phosphoreszenten Exzitonenfänger enthält. Ferner weist die Emitterschicht dann zumindest eine zweite Teilschicht (d. h. Teilschicht(en) eines zweiten Typs) auf, bei der das Matrixmaterial nur den phosphoreszenten Exzitonenfänger aber keinen fluoreszierenden strahlungsemittierenden Emitter enthält.

Bei einer derartigen Ausführungsform werden Triplettexzitonen zunächst auf dem Matrixmaterial (oder auch auf dem Exzitonenfänger) gebildet und auf den phosporeszenten Exzitonenfänger übertragen. Die Triplettexzitonen diffundieren dann in Richtung der Grenzfläche zwischen erster und zweiter Teilschicht und werden schließlich auf den fluoreszierenden Emitter übertragen.

In einer nicht erfinderischen Variante befindet sich dabei eine Teilschicht, die (nur) den phosphoreszenten Exzitonenfänger enthält zwischen zwei Teilschichten, die jeweils (nur) den fluoreszierenden Emitter enthalten. In diesem Fall können die Triplettexzitonen von den Molekülen des phosphoreszenten Exzitonenfängers ungerichtet in alle Richtungen diffundieren und treffen dennoch auf eine Grenzfläche zur anderen Teilschicht.

Liegen mehrere Teilschichten vor, so kann das für die jeweiligen Teilschichten verwendete Matrixmaterial gleich oder verschieden sein. Häufig wird das Matrixmaterial, das den phosphoreszenten Exzitonenfänger enthält bezüglich des Triplett-Niveaus auf das Triplett-Niveau des Exzitonenfängers abgestimmt sein. Eine kathodenseitig an die den Exzitonenfänger enthaltende Teilschicht angrenzende Teilschicht kann beispielsweise als Matrixmaterial das selbe Material aufweisen, wie eine wiederum kathodenseitig an diese Teilschicht angrenzende Lochblockier-Schicht, Elektronentransport-Schicht oder ElektronenInjektionsschicht. Eine anodenseitig an die den phosphoreszierenden Exzitonenfänger angrenzende Teilschicht kann zum Beispiel das selbe Matrixmaterial aufweisen, wie eine wiederum kathodenseitig an diese Teilschicht angrenzende Elektronenblockier-Schicht, Lochtransport-Schicht oder Lochinjektions-Schicht. Alternativ kann natürlich das Matrixmaterial der Teilschicht beziehungsweise der Teilschichten, die den fluoreszierenden Emitter enthalten, auch aus einem Matrixmaterial bestehen, das zwar nicht dem zuvor beschriebenen kathodenseitig beziehungsweise anodenseitig an diese Teilschichten angrenzenden Matrixmaterial entspricht, aber aus den vorstehend angegebenen Matrixmaterialien ausgewählt ist. Dem entsprechend ist insbesondere für eine kathodenseitig angeordnete Teilschicht mit fluoreszentem Emitter jegliches lochblockierende und Elektronen transportierende Matrixmaterial geeignet, für eine anodenseitig angeordnete Teilschicht mit fluoreszierenden Emittern jegliches elektronenblockierende und lochtransportierende Matrixmaterial. In beiden Fällen kann das Matrixmaterial zudem so ausgewählt sein, dass es auch exzitonenblockierende Eigenschaften besitzt. Dies hat den Effekt, dass in der Teilschicht, die den Exzitonenfänger enthält, gebildete Exzitonen nicht auf das Matrixmaterial der Teilschicht mit den fluoreszierenden Emitter übertragen werden kann, sondern im Wesentlichen nur auf das Singulett-Niveau des fluoreszierenden Emitters übertragen wird und hier (in Nähe der Grenzfläche zwischen den Teilschichten) strahlend zerfallen kann.

In der erfinderischen Ausführungsform weist die Emitterschicht keine Teilschichten auf (die jeweils nur dem fluoreszierenden strahlungsemittierenden Emitter und das Matrixmaterial oder nur den phosphoreszenten Exzitonenfänger und das Matrixmaterial enthalten). In diesem Fall sind die Moleküle des phosphoreszenten Exzitonenfängers und die des fluoreszierenden Emitters statistisch über die gesamte Emitterschicht verteilt.

Der fluoreszierende Emitter und auch der phosphoreszente Exzitonenfänger sind statistisch über das Matrixmaterial verteilt. In einer nicht erfinderischen Ausführungsform können auch Konzentrationsgradienten in der Emitterschicht vorliegen, so dass sich beispielsweise Bereiche, in denen der Exzitonenfänger höher konzentriert ist mit Bereichen, in denen der fluoreszierende Emitter im Verhältnis höher konzentriert ist, abwechseln; es können in der Emitterschicht sogar auch nur Bereiche vorliegen (die aber noch keine echte Teilschicht darstellen), in denen ausschließlich Exzitonenfänger enthalten ist und Bereiche in denen ausschließlich der phosphoreszente Emitter enthalten ist. Hiermit können gezielt Zonen eingestellt werden, in denen hauptsächlich Exzitonen gebildet werden beziehungsweise Zonen, in denen hauptsächlich die Emission erfolgt.

Generell können durch das erfindungsgemäße (Molekül-Verhältnis) zwischen fluoreszierenden strahlungsemittierendem Emitter und phosphoreszentem Exzitonenfänger nicht strahlende Konkurrenzprozesse wie beispielsweise eine direkte Bildung von Triplettexzitonen auf dem fluoreszierenden Dotierstoff oder eine Triplett-Triplett-Anihilation auf dem phosphoreszenten Exzitonenfänger minimiert werden.

In Ausführungsformen ist der Gewichtsanteil des phosphoreszenten Exzitonenfängers zumindest viermal, häufig sogar zumindest achtmal so hoch wie der des fluoreszierenden strahlungsemittierenden Emitters.

In einer weiteren Ausführungsform beträgt der Anteil des phosphoreszenten Exzitonenfängers 10 - 20 Gew.-% (im Rahmen der vorliegenden Erfindung beziehen sich alle Angaben in Gew.-% stets auf das in der Emitterschicht enthaltene Matrixmaterial). Ab einem Gewichtsanteil von mindestens 10 Gew.-% ist im Matrixmaterial so viel Exzitonenfänger enthalten, dass ein sehr effizienter Transport der Ladungsträger ermöglicht wird und daher ein deutlicher Anstieg der Stromeffizienz zu verzeichnen ist. Ab einem Anteil von 20 Gew.-% kann es unter Umständen verstärkt dazu kommen, dass durch Wechselwirkungen von zwei Exzitonen Effizienzverluste erfolgen.

In einer weiteren Ausführungsform ist der Anteil des fluoreszierenden Emitters 1 - 4 Gew.-%. Ab einem Gewichtsanteil von 5 Gew.-% ist - abhängig vom jeweiligen Emitter - mit einem Konzentrationsquenching und daher einer deutlich sinkenden Effizienz zu rechnen.

In einer Ausführungsform weist der phosphoreszente Exzitonenfänger das Emissionsmaximum bei einer kürzeren Wellenlänge auf als der strahlungsemittierende Emitter.

Dies gewährleistet im Regelfall, dass eine effiziente Energietransferkaskade vom phosphoreszenten Exzitonenfänger zum Singulettniveau des fluoreszierenden Emitters stattfinden kann. Insbesondere sollte das Triplettniveau des Matrixmaterials (T1_{Matrix}) höher liegen als das Triplettniveau des Exzitonenfängers (T1_{Exzitonenfänger}), das wiederum höher liegen muss als das Singulettniveau des fluoreszierenden Emitters (S1_{Emitter}). Wie beschrieben, werden dann die Triplettexzitonen auf dem Matrixmaterial gebildet, auf den phosphoreszenten Exzitonenfänger übertragen, der die Triplett-Exzitonen dann auf den Singulettzustand des fluoreszierenden Emitters überträgt (und insbesondere nicht an das Matrixmaterial einer Teilschicht mit dem fluoreszierenden Emitter abgeben kann - sofern Teilschichten der Emitterschicht vorliegen und diese Teilschichten unterschiedliche Matrixmaterialien aufweisen).

In einer weiteren Ausführungsform beträgt die Differenz der Wellenlängen des Emissionsmaximums des strahlungsemittierenden Emitters und des Emissionsmaximums des Exzitonenfängers 1 nm bis 100 nm, bevorzugt zumindest 15 nm oder zumindest sogar 30 nm bis 100 nm. Dann ist im Regelfall ebenfalls eine effiziente Energietransferkaskade möglich.

In einer weiteren Ausführungsform zeichnet sich die strahlungsemittierende Vorrichtung dadurch aus, dass die mittlere Lebensdauer der Emitterschicht (bei einer Leuchtdichte von 300 cd/m²) gegenüber der mittleren Lebensdauer einer strahlungsemittierenden Vorrichtung, die sich nur darin unterscheidet, dass die Emitterschicht nur den phosphoreszenten Exzitonenfänger (und nicht den fluoreszierenden Emitter) enthält, um mindestens 50 Prozent erhöht ist. Häufig kann sogar eine Erhöhung der mittleren Lebensdauer um 100 Prozent beobachtet werden. Auch Erhöhungen um bis zu 300 Prozent oder um bis zu 500 Prozent werden beobachtet.

Die erfindungsgemäße strahlungsemittierende Vorrichtung weist dann (bei einer Leuchtdichte von 300 cd/m²) im Regelfall eine mittlere Lebensdauer von mindestens 10.000 Stunden, häufig von mindestens 20.000 Stunden auf. Auch Lebensdauern von 50.000 Stunden sind realisierbar.

In einer weiteren Ausführungsform wird die von der Emitterschicht emittierte Strahlung im Wesentlichen durch den strahlungsemittierenden Emitter erzeugt. Aufgrund der sehr guten Ladungsträger- und Exzitonenleitfähigkeit des phosphoreszenten Exzitonenfängers werden die in Matrixmaterial oder auf dem phosphoreszenten Exzitonenfänger gebildeten Exzitonen zu einem Großteil auf das fluoreszierende Emittermaterial übertragen, was beispielsweise anhand des Emissionsspektrums erkennbar ist. Üblicherweise beträgt die Intensität der normalisierten Emission des Emissionsmaximums des Exzitonenfängers in einem für die Emitterschicht mit Exzitonenfänger und strahlungsemittierendem Emitter gemessenen Spektrum maximal 40% der Intensität des Emissionsmaximums des strahlungsemittierenden Emitters, häufig bei maximal 20%. Meist liegt die Intensität des Emissionsmaximums des Exzitonenfängers sogar nur bei maximal 10%, häufig sogar bei maximal 5% der Intensität des Emissionsmaximums des strahlungsemittierenden Emitters. Die gemessenen Intensitätsverhältnisse sind hierbei üblicherweise unabhängig von der Stromdichte, insbesondere bei Stromdichten zwischen 0,5 und 10 mA/cm².

Üblicherweise ist es zudem so, dass auch die Intensität des Emissionsmaximums des phosphoreszenten Exzitonenfängers in einer Emitterschicht mit Exzitonenfänger und strahlungsemittierendem Emitter deutlich gegenüber der Intensität des Emissionsmaximums einer Emitterschicht, die nur den Exzitonenfänger (in gleicher Konzentration wie im vorstehend genannten "gemischten" System) und kein strahlungsemittierendes Emittermaterial (sowie keine Teilschichten) enthält, reduziert ist. Üblicherweise beträgt die (bei gleicher Stromdichte von z.B. 5 mA/cm² gemessene) Intensität der normalisierten Emission des Emissionsmaximums des Exzitonenfängers in der Emitterschicht mit Emitter und Exzitonenfänger dann maximal 40%, meist maximal 20%, häufig maximal 10 % und oft sogar maximal 5% der normalisierten Emission des Emissionsmaximums des Exzitonenfängers in einer Schicht, die nur aus dem Matrixmaterial und dem Exzitonenfänger besteht. Wie vorstehend beschrieben wurde, ist dies im Wesentlichen auf die gute Exzitonenleitfähigkeit des Exzitonenfängers zurückzuführen. Die gemessenen Intensitätsverhältnisse sind hierbei üblicherweise unabhängig von der Stromdichte, insbesondere bei Stromdichten zwischen 0,5 und 10 mA/cm².

In den meisten Ausführungsformen ruft das von der Emitterschicht emittierte Licht im Wesentlichen denselben Farbeindruck hervor wie das Licht, das von einer Emitterschicht ohne Exzitonenfänger (sowie ohne Teilschichten) emittiert wird, hervorruft. Unter einem im Wesentlichen gleichen Farbeindruck wird hierbei insbesondere verstanden, dass die CIE-Koordinaten des emittierten Lichts einer Emitterschicht ohne Exzitonenfänger (x_{oE}, y_{oE}) sich nicht wesentlich von denen einer Emitterschicht mit Exzitonenfänger (x_{mE}, y_{mE}) unterscheiden. Im Regelfall gilt für die Differenz Δx = x_{oE} - x_{mE} bzw. die Differenz Δy = y_{oE} - y_{mE}, dass Δx < 0,05 und/oder Δy < 0,05. Häufig gilt sogar Δx < 0,03 und/oder Δy < 0,03 und vielfach auch Δx < 0,01 und/oder Δy < 0,01. Für die Summe der Absolutbeträge dieser Differenzen ∑_{Δ} = |Δx| + |Δy| gilt im Regelfall ∑_{Δ} < 0,08, häufig gilt ∑_{Δ} < 0,05 und vielfach auch ∑_{Δ} < 0,01.

Der gute Transfer der Exzitonen vom Exzitonenfänger auf den Dotierstoff kann anhand der zeitaufgelösten wellenlängenabhängigen Emissionsspektren bestimmt werden. Vergleicht man hier eine Emitterschicht, die einen phosphoreszenten Exzitonenfänger und ein fluoreszierendes Emittermaterial enthält, mit einer identischen Schicht, die in denselben Konzentrationen jeweils nur den Exzitonenfänger (sowie keine Teilschichten) beziehungsweise nur das strahlungsemittierende Emittermaterial (sowie keine Teilschichten) enthält, so stellt man fest, dass sich die Halbwertszeit der Intensität der Emission des Emissionsmaximums des Exzitonenfängers im "gemischten System" reduziert hat während die Halbwertszeit der Intensität der Emission des Emissionsmaximums des fluoreszierenden Emittermaterials im Wesentlichen gleich bleibt oder sogar etwas zunimmt.

In einer bevorzugten Ausführungsform ist in der erfindungsgemäßen Emitterschicht die Halbwertszeit der Exzitonenlebensdauer auf dem Exzitonenfänger kleiner oder gleich 10 µs, vorzugsweise kleiner oder gleich 1 µs. Für derartige Systeme ist ein besonders hoher Singulett-Anteil in den gebildeten Triplett-Exzitonen zu verzeichnen.

Die vorstehend beschriebenen Effekte führen im Regelfall auch dazu, dass die externe Quanteneffizienz der Emitterschicht deutlich erhöht werden kann. Vergleicht man die externe Quanteneffizienz einer Emitterschicht mit phosphoreszentem Exzitonenfänger und fluoreszierendem strahlungsemittierendem Emitter mit der Quanteneffizienz einer Emitterschicht, die nur den fluoreszierenden Emitter (in der gleichen Konzentration) und keinen Exzitonenfänger enthält, so stellt man fest, dass die Quanteneffizienz zumeist um mindestens 20% erhöht ist. Häufig kann sogar eine Erhöhung um 30% festgestellt werden. Mit der erfindungsgemäßen Emitterschicht können daher externe Quanteneffizienzen ηₑₓₜ größer 12%, häufig sogar größer 14% erreicht werden. Es können sogar Quanteneffizienzen zwischen über 18%, z.B. von 20% erreicht werden.

Häufig ist es zudem so, dass die Quanteneffizienz der erfindungsgemäßen Emitterschicht zumindest 75 Prozent der Quanteneffizienz einer Emitterschicht, die nur den fluoreszierenden Emitter und keinen phosphoreszenten Exzitonenfänger (so wie keine Teilschichten) enthält, beträgt. Vielfach ist es sogar so, dass die Quanteneffizienz der erfindungsgemäßen Emitterschicht gleich oder höher ist, wie die der vorstehend genannten Emitterschicht, die nur den fluoreszierenden Emitter enthält.

In einer weiteren Ausgestaltung weist der in der Emitterschicht enthaltene strahlungsemittierende Emitter eine hohe Photolumineszenzquantenausbeute auf, insbesondere auch bei niedrigen Konzentrationen des fluoreszierenden Emitters. Weiterhin besitzen die Exzitonen auf dem fluoreszierenden strahlungsemittierenden Emittermaterial eine relativ kurze Lebensdauer. Im Regelfall beträgt diese maximal 100 ns.

In einer weiteren Ausgestaltung hat die Emitterschicht der strahlungsemittierenden Vorrichtung eine Schichtdicke von 10 - 40 nm. Emitterschichten mit geringeren Schichtdicken sind schwerer zu prozessieren; außerdem kann ab einer Schichtdicke von 10 nm die Anzahl der Emitterzentren optimiert werden und damit besser an die Lebensdauer der Exzitonen angepasst werden. Es kann aber auch eine Schichtdicke zwischen 5 und 10 nm technisch sinnvoll sein. Wenn die Emitterschichten 2, 3 oder mehr Teilschichten aufweist (nicht Teil dieser Erfindung), wird die Schichtdicke der einzelnen Teilschichten häufig 5-10 nm betragen. Für die Herstellung einer weißes Licht emittierenden strahlungsemittierenden Vorrichtung, die neben der erfindungsgemäßen blaues oder violettes Licht emittierenden Emitterschicht weitere Emitterschichten enthält, beträgt die Schichtdicke der einzelnen Emitterschichten bevorzugt jeweils 10 - 20 nm.

In einer weiteren Ausführungsform kann also die strahlungsemittierende Vorrichtung zumindest eine weitere Emitterschicht, häufig insgesamt zumindest zwei oder drei Emitterschichten, aufweisen. Insbesondere ist eine derartige Anordnung geeignet, um eine strahlungsemittierende Vorrichtung, die Weißlicht emittiert, zu erzeugen. Dieses Weißlicht kann gebildet werden durch die Überlagerung der Strahlung, die durch die erste Emitterschicht und die zumindest eine weitere Emitterschicht emittiert wird. Üblicherweise werden hierfür zumindest drei Emitterschichten (zum Beispiel Emitterschichten die jeweils im roten, grünen und blauen Spektralbereich emittieren) verwendet. Denkbar ist allerdings auch ein System, das nur zwei Emitterschichten (beispielsweise eine blau und eine orange emittierende Schicht) enthält. Erfindungsgemäß sind hierbei und generell die verschiedenen Spektralbereiche folgendermaßen definiert: roter Spektralbereich etwa 640 bis 780 nm, oranger Spektralbereich etwa 600 bis 640 nm, gelber Spektralbereich etwa 570 bis 600 nm, grüner Spektralbereich etwa 500 bis 570 nm, blauer Spektralbereich etwa 430 bis 500 nm, violetter Spektralbereich etwa 380 bis 430 nm.

In einer weiteren Ausführungsform der vorliegenden Erfindung liegen zwischen jeweils zwei der im vorstehenden Absatz genannten Emitterschichten Blockierschichten vor. Enthält die strahlungsemittierende Vorrichtung mehr als zwei Emitterschichten, so kann zwischen allen Emitterschichten eine Blockierschicht vorliegen aber auch nur zwischen einem Teil der Emitterschichten. Eine solche Blockierschicht kann zum Blockieren von Exzitonen dienen und dabei so gestaltet sein, dass ihre Dicke größer ist als die mittlere freie Weglänge der in der jeweils benachbarten Schicht gebildeten Exzitonen, so dass diese im Wesentlichen nicht in die zweite Schicht gelangen können. Ferner kann die Blockierschicht alternativ oder gleichzeitig auch zumindest in Teilen der Schicht zum Blockieren von Ladungsträgern (Elektronen oder Löchern) dienen. Durch Schichten oder Teilbereiche von Schichten, die Ladungsträger blockieren kann eine gezielte Einstellung der Ladungsträgerdichte erfolgen. Eine Blockierschicht zum Blockieren von Exzitonen und/oder Ladungsträgern kann ein oder mehrere Matrixmaterialien umfassen oder hieraus bestehen, wobei geeignete Matrixmaterialien aus den vorstehend offenbarten Matrixmaterialien ausgewählt werden können. Alternativ können Schichten die Elektronen blockieren eines oder mehrere der nachfolgenden Materialien für Lochtransport-Schichten umfassen oder diese(s) und ein oder mehrere Matrixmaterialien umfassen. Ferner können Schichten die Löcher blockieren eines oder mehrere der nachfolgenden Materialien für Elektronentransport-Schichten umfassen oder diese(s) und ein oder mehrere Matrixmaterialien umfassen.

In einer Ausführungsform ist die strahlungsemittierende Vorrichtung eine OLED und kann insbesondere als Beleuchtungseinrichtung oder als Display ausgebildet sein und eine großflächig ausgebildete aktive Leuchtfläche aufweisen. "Großflächig" kann dabei bedeuten, dass das Bauelement eine Fläche von größer oder gleich einigen Quadratmillimetern, bevorzugt größer oder gleich einem Quadratzentimeter und besonders bevorzugt größer oder gleich einem Quadratdezimeter aufweist.

Die erfindungsgemäße strahlungsemittierende Vorrichtung kann weitere funktionelle Schichten aufweisen. Solche Schichten können beispielsweise Elektronentransportschichten, Elektroneninjektionsschichten, Lochtransportschichten und/oder Lochinjektionsschichten sein. Solche Schichten können dazu dienen, die Effizienz der strahlungsemittierenden Vorrichtung weiter zu steigern und an einer oder mehreren geeigneten Stellen der strahlungsemittierenden Vorrichtung ausgebildet werden. Sie können geeignete Elektronentransportmaterialien und/oder Lochtransportmaterialien und/oder zur Verbesserung der Lochinjektion geeignete Materialien sowie Materialien zum Blockieren von Exzitonen oder Ladungsträgern umfassen. Als Elektronentransportmaterialien seien beispielsweise Liq (8-Hydroxychinolinolato-lithium), TPBi (2,2',2"-(1,3,5-Benzintriyl)-tris(1-phenyl-1-H-benzimidazol)), PBD (2-(4-Biphenylyl)-5-(4-tert-butylphenyl)-1,3,4-oxadiazol), BCP (2,9-Dimethyl-4,7-diphenyl-1,10-phenanthrolin), BPhen (4,7-Diphenyl-1,10-phenanthrolin), BAlq (Bis-(2-methyl-8-chinolinolat)-4-(phenylphenolato)aluminium), TAZ (3-(4-Biphenylyl)-4-phenyl-5-tert-butylphenyl-1,2,4-triazol), CzSi (3,6-bis(triphenylsilyl)carbazol), NTAZ (4-(Naphth-1-yl)-3,5-diphenyl-4H-1,2,4-triazol), Bpy-OXD (1,3-Bis[2-(2,2'-bipyrid-6-yl)-1,3,4-oxadiazol-5-yl]benzol), BP-OXD-Bpy (6,6'-Bis[5-(biphenyl-4-yl)-1,3,4-oxadiazol-2-yl]-2,2'-bipyridyl), PADN (2-phenyl-9,10-di(naphth-2-yl)-anthracene), Bpy-FOXD (2,7-Bis[2-(2,2'-bipyrid-6-yl)-1,3,4-oxadiazol-5-yl]-9,9-dimethylfluoren), OXD-7 (1,3-Bis[2-(4-tert-butylphenyl)-1,3,4-oxadiazol-5-yl]benzol), HNBphen (2-(naphth-2-yl)-4,7-diphenyl-1,10-phenanthrolin), NBphen (2,9-Bis(naphth-2-yl)-4,7-diphenyl-1,10-phenanthrolin), 3TPYMB (Tris(2,4,6-trimethyl-3-(pyrid-3-yl)phenyl)boran) und 2-NPIP (1-methyl-2-(4-(naphth-2-yl)phenyl)-1H-imidazo[4,5-f] [1,10]phenanthrolin) sowie Gemische der vorgenannten Stoffe genannt. Für die Elektronentransportschicht (die zugleich als Exzitonen-Blockierschicht und/oder Loch-Blockierschicht dienen kann) werden bevorzugt Stoffe ausgewählt aus der Gruppe, bestehend aus TPBi, BCP, Bphen, CzSi und TAZ sowie aus Gemischen dieser Stoffe.

Als Lochtransportmaterialien seien zum Beispiel NPB (N,N'-Bis(naphth-1-yl)-N,N'-bis(phenyl)-benzidin, β-NPB (N,N'-Bis(naphth-2-yl)-N,N'-bis(phenyl)-benzidin), TPD (N,N'-Bis(3-methylphenyl)-N,N'-bis(phenyl)-benzidin), N,N'-Bis(naphth-1-yl)-N,N'-bis(phenyl)-2,2-dimethylbenzidin, Spiro-TPD (N,N'-Bis(3-methylphenyl)-N,N'-bis(phenyl)-9,9-spirobifluorene), Spiro-NPB (N,N'-Bis(naphth-1-yl)-N,N'-bis(phenyl)-9,9-spirobifluorene), DMFL-TPD (N,N'-Bis(3-methylphenyl)-N,N'-bis(phenyl)-9,9-dimethylfluoren, DMFL-NPB (N,N'-Bis(naphth-1-yl)-N,N'-bis(phenyl)-9,9-dimethylfluoren), DPFL-TPD (N,N'-Bis(3-methylphenyl)-N,N'-bis(phenyl)-9,9-diphenylfluoren), DPFL-NPB (N,N'-Bis(naphth-1-yl)-N,N'-bis(phenyl)-9,9-diphenylfluoren), Sp-TAD (2,2',7,7'-Tetrakis(n,n-diphenylamino)-9,9'-spirobifluoren), TAPC (Di-[4-(N,N-ditolyl-amino)-phenyl]cyclohexan), Spiro-TTB (2,2',7,7'-tetra(N, N-di-tolyl)amino-spiro-bifluoren), BPAPF (9,9-Bis[4-(N,N-bis-biphenyl-4-yl-amino)phenyl]-9H-fluoren), Spiro-2NPB (2,2',7,7'-Tetrakis[N-naphthyl(phenyl)-amino]-9,9-spirobifluoren), Spiro-5 (2,7-Bis[N,N-bis(9,9-spirobifluoren-2-yl)-amino]-9,9-spirobifluoren), 2,2'-Spiro-DBP (2,2'-Bis[N,N-bis(biphenyl-4-yl)amino]-9,9-spirobifluoren), PAPB (N, N'-bis(phenanthren-9-yl)-N,N'-bis(phenyl)-benzidin), TNB (N, N,N',N'-tetra-naphth-2-yl-benzidin), Spiro-BPA (2,2'-Bis(N,N-di-phenyl-amino)-9,9-spirobifluoren), NPAPF (9,9-Bis[4-(N,N-bis-naphth-2-yl-amino)phenyl]-9H-fluoren), NPBAPF (9,9-Bis[4-(N,N'-bis-naphth-2-yl-N,N'-bis-phenyl-amino)-phenyl]-9H-fluoren), TiOPC (Titanoxide phthalocyanin), CuPC (Kupfer-Phthalocyanin), F4-TCNQ (2,3,5,6-Tetrafluor-7,7,8,8,-tetracyano-chinodimethan), m-MTDATA (4,4',4"-Tris(N-3-methylphenyl-N-phenyl-amino)triphenylamin), 2T-NATA (4,4',4" -Tris(N-(2-naphthyl)-N-phenyl-amino)triphenylamin), 1T-NATA (4,4',4"-Tris(N-(1-naphthyl)-N-phenyl-amino)triphenylamin), NATA (4,4',4"-Tris(N,N-diphenyl-amino)triphenylamin), PPDN (Pyrazino[2,3-f][1,10]phenanthrolin-2,3-dicarbonitril), MeO-TPD (N, N,N' ,N' -Tetrakis(4-methoxyphenyl)benzidin), MeO-Spiro-TPD (2,7-Bis[N,N-bis(4-methoxy-phenyl)amino]-9,9-spirobifluoren), 2,2'-MeO-Spiro-TPD (2,2'-Bis[N,N-bis(4-methoxy-phenyl)amino]-9,9-spirobifluoren), β - NPP (N,N'-di(naphth-2-yl)-N,N'-diphenylbenzol-1,4-diamin), NTNPB (N,N'-di-phenyl-N,N'-di-[4-(N, N-di-tolyl-amino)phenyl]benzidin) und NPNPB (N,N'-di-phenyl-N,N'-di-[4-(N, N-di-phenyl-amino)phenyl]benzidin) oder Gemische der vorgenannten Stoffe genannt. Für die Lochtransport-Schicht (die ebenfalls gleichzeitig als Exzitonen-Blockierschicht und/oder Elektronen-Blockierschicht dienen kann) werden bevorzugt Stoffe ausgewählt aus der Gruppe, bestehend aus NPB, TCTA, TPD, Sp-TAD und TAPC sowie aus Gemischen dieser Stoffe. Als zur Verbesserung der Lochinjektion geeignete Materialien, seien beispielsweise CuPC (Phthalocyanin, Kupferkomplex), TiOPC (Titanoxidphthalocyanin), m-MTDATA (4,4',4"-Tris(N-3-methylphenyl-N-phenylamino)triphenylamin), 2T-NATA (4,4',4"-Tris(N-(2-naphthyl)-N-phenyl-amino)triphenylamin), IT-NATA (4,4',4''-Tris(N-(1-naphthyl)-N-phenylamino)triphenylamin), NATA (4,4',4''-Tris(N,N-diphenylamino)triphenylamin) sowie Gemische der vorgenannten Stoffe genannt, wobei die angegebenen Materialien optional dotiert sein können.

Im folgenden wird die vorliegende Erfindung anhand von Beispielen und Figuren beschrieben.
- Figur 1: zeigt eine schematische Übersicht über eine strahlungsemittierende Vorrichtung gemäß der vorliegenden Erfindung.
- Figur 2: zeigt eine schematische Darstellung der Energieniveaus einer Ausführungsform einer OLED-Struktur gemäß der vorliegenden Erfindung (ohne Teilschichten).
- Figur 3: zeigt eine schematische Darstellung der Energieniveaus einer weiteren Ausführungsform einer OLED-Struktur (nicht Teil der vorliegenden Erfindung) mit einer ersten Teilschicht mit dem fluoreszierenden strahlungsemittierenden Emitter und einer zweiten Teilschicht mit den phosphoreszenten Exzitonenfänger.

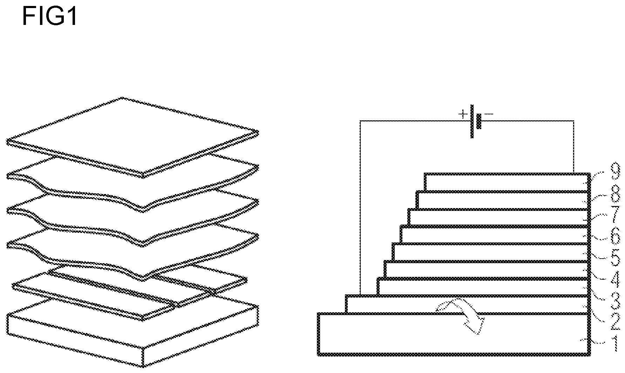

Die Figur 1 zeigt den schematisierten Schichtaufbau eines organischen strahlungsemittierenden Bauteils. Von unten nach oben ist folgender Schichtaufbau realisiert: Zu unterst befindet sich das Substrat 1, das beispielsweise transparent sein kann und auch aus Glas sein kann. Darauf befindet sich eine untere Elektrodenschicht 2, die beispielsweise ein transparentes leitendes Oxid wie Indium-Zinn-Oxid (ITO) sein kann. Die untere Elektrodenschicht kann dabei als Anode oder als Kathode fungieren. Über dieser Elektrodenschicht 2 liegt eine Lochinjektionsschicht 3 über der wiederum eine Lochtransport-Schicht 4 angeordnet ist. Über der Lochtransport-Schicht 4 ist die organisch aktive Schicht, die Emissionsschicht 5, angeordnet. Enthält die strahlungsemittierende Vorrichtung mehr als eine Emissionsschicht 5, so folgen auf die erste Emissionsschicht die weiteren Emissionsschichten, die gegebenenfalls durch Exzitonen-Blockierschichten getrennt sind. Auf der einen beziehungsweise den mehreren Emissionsschichten liegt die lochblockierende Schicht 6, auf der die Elektronentransportschicht 7 und schließlich die Elektroneninjektionsschicht 8 mit angrenzender oberer Elektrode 9 angeordnet sind. Die obere Elektrode 9 kann beispielsweise eine Metallelektrode oder eine weitere transparente Elektrode, zum Beispiel aus einem der vorstehend genannten transparenten leitenden Oxide sein.

Bei Anlegen einer Spannung zwischen oberer und unterer Elektrode fließt Strom durch das Bauteil und in der organisch aktiven Schicht werden Photonen freigesetzt, die in Form von Licht über die transparente Elektrode beziehungsweise die transparenten Elektroden das Bauteil verlassen.

In der Emissionsschicht 5 sind erfindungsgemäß in einer Matrix ein oder mehrere phosphoreszente Exzitonenfänger und ein oder mehrere fluoreszierende strahlungsemittierende Emitter (letztere insbesondere in niedriger Konzentration) vorgesehen.

Die Herstellung eines derartigen strahlungsemittierenden Bauelements kann zum Beispiel folgendermaßen erfolgen: Mittels HF-Sputtern wird zunächst eine ITO-Schicht als Anode auf einer Glasplatte abgeschieden. Zur Abscheidung der weiteren funktionellen Schichten wird dieses Substrat in einen Rezipienten eingebracht; dieser enthält mehrere Quellen, in denen organisches Material (insbesondere zur Verwendung als Exzitonenfänger sowie zur Verwendung als strahlungsemittierender Emitter) zur Herstellung der einzelnen funktionellen Schichten der strahlungsemittierenden Vorrichtung verdampft werden kann. Ferner werden eine oder mehrere Quellen für die Zuführung von einem oder mehreren verschiedenen Matrixmaterialien vorgesehen. Zur Ausbildung einer Lochinjektionsschicht wird aus einer Quelle mit Matrixmaterial und einer Quelle mit einem P-Dotanden gemeinsam auf der Glasplatte, auf der bereits die Anode vorliegt, abgeschieden. Entsprechend erfolgt die gemeinsame Abscheidung von Dotand und Matrixmaterial für die Lochtransport-Schicht. Anschließend erfolgt die Abscheidung der erfindungsgemäßen Emitterschicht. Hierfür werden ein Matrixmaterial, der Exzitonenfänger und das mindestens eine strahlungsemittierende Emittermaterial gemeinsam abgeschieden.

Um eine Schicht mit im Wesentlichen statistisch verteilten Exzitonenfänger-Molekülen und Molekülen des fluoreszierenden Emitters zu erhalten, werden Matrixmaterial, Exzitonenfänger und Emittermaterial gleichzeitig abgeschieden. Zur Erzeugung von Teilschichten innerhalb der Emitterschicht werden Emittermaterial und Exzitonenfänger nicht gleichzeitig abgeschieden (nicht Teil der vorliegenden Erfindung). Beispielsweise kann zunächst gleichzeitig Matrixmaterial und fluoreszierender Emitter abgeschieden werden (erste Teilschicht), nachfolgend phosphoreszente Exzitonenfänger und Matrixmaterial (zweite Teilschicht) und schließlich Matrixmaterial und fluoreszierender Emitter (dritte Teilschicht). Die Abscheidung weiterer enthaltener Schichten wie Blockierschicht, Elektronentransportschicht und Elektroneninjektionsschicht erfolgt analog. Abschließend wird eine Aluminiumschicht als reflektierende Elektrode gebildet. Alternativ können (abgesehen von den Elektrodenschichten) die verschiedenen funktionellen Schichten auch mittels eines Nassprozesses (z.B. Spincoating) aufgebracht werden, dies kann insbesondere sinnvoll sein, wenn die aufzubringende Schicht ein Polymer enthält. Weiterhin können auch die zuerst aufgebrachten Schichten mittels eines Nassprozesses und alle darauf angeordneten Schichten mittels Aufdampfen aufgebracht werden.

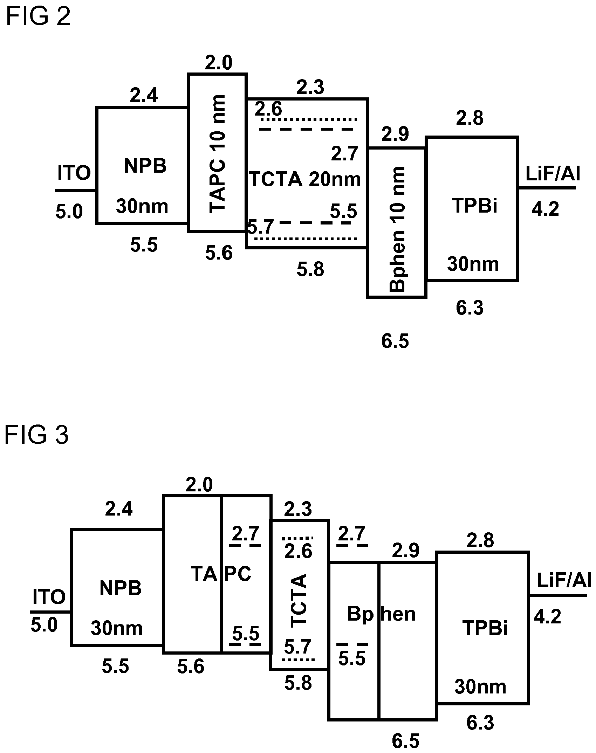

Im folgenden wird ein Ausführungsbeispiel zur Herstellung einer OLED, die blaues Licht emittiert, angegeben. Die schematische Struktur dieser blau emittierenden OLED ist in den Figuren 2 und 3 abgebildet.

Die blaues Licht emittierende OLED weist eine auf die ITO-Anode aufgebrachte Lochtransport-Schicht aus NPB, die 30 nm dick ist, auf. Auf der Lochtransportschicht ist eine Exzitonen-Blockierschicht aus TAPC mit einer Dicke von 10 nm angeordnet, um einen Transfer der Exzitonen aus der Emitterschicht auf die weniger effiziente Lochtransport-Schicht zu vermeiden. Auf der Kathode aus LiF/Al ist eine 30 nm dicke Elektronentransportschicht aus TPBi angeordnet. Auf dieser befindet sich wiederum eine 10 nm dicke Schicht aus Bphen, die als Exzitonen-Blockierschicht und Loch-Blockierschicht fungiert. Die Emitterschicht selbst umfasst das Matrixmaterial TCTA, in das der blau phosphoreszierende Exzitonenfänger fac-Ir(cn-pmic)₃ (Energieniveaus in der Figur 2 durch Punkte gekennzeichnet) und der blau fluoreszierende Emitter DPAVBi (Energieniveaus in Figur 2 durch Striche gekennzeichnet) eingebracht sind. Die Emitterschicht hat eine Schichtdicke von 30 nm. Die Exzitonen werden dann zunächst auf dem Matrixmaterial TCTA generiert und über den phosphoreszenten Exzitonenfänger Ir(pmb)₃ zum fluoreszierenden Emitter DPAVBi transferiert, wo sie strahlend zerfallen können. Der Exzitonenfänger liegt in diesem Ausführungsbeispiel in einer Konzentration von 20 Gew.-% vor; hierdurch erfolgt eine gute direkte Exzitonenbildung sowie ein sehr guter Transfer von auf dem Matrixmaterial gebildeten Exzitonen auf den Exzitonenfänger. Des weiteren können die Exzitonen aufgrund der hohen Konzentration gut über die Exzitonenfänger-Moleküle zu den fluoreszierenden Emitter-Molekülen diffundieren. Das Triplettniveau des phosphoreszenten Exzitonenfängers (sowie das der Matrix) kann aus der Emissionswellenlänge der Phosphoreszenz (der Matrix bzw. des Exzitonenfängers) berechnet werden. Das Singulettniveau des fluoreszierenden Emitters kann durch Messung der Emissionswellenlänge bei Raumtemperatur bestimmt werden.

Figur 3 zeigt einen Aufbau, der dem der Figur 2 entspricht; allerdings ist die Emitterschicht hier durch drei Teilschichten gebildet (nicht Teil der vorliegenden Erfindung) . Der phosphoreszente Exzitonenfänger fac-Ir(pmb)₃ befindet sich (in einer Konzentration von 20 Gew.-%) in der mittleren, 10 nm dicken Schicht aus dem Matrixmaterial TCTA. Daran angrenzend sind zwei jeweils 10 nm dicke Schichten mit dem fluoreszierenden Emitter DPAVBi angeordnet. Die anodenseitig an die mittlere Teilschicht der Emitterschicht angrenzende Teilschicht weist dabei das Matrixmaterial TAPC auf, die kathodenseitig daran angrenzende Teilschicht das Matrixmaterial Bphen. Die Energieniveaus des phosphoreszenten Exzitonenfängers sind jeweils durch Punkte gekennzeichnet, die des fluoreszierenden Emitters durch Striche. In dieser Ausführungsform werden also Exzitonen auf dem Matrixmaterial TCTA (sowie auf dem Exzitonenfänger) gebildet und können dann in Richtung der Grenzflächen zu den jeweils angrenzenden Teilschichten ist, können die Exzitonen nicht auf das Matrixmaterial der fluoreszierenden Emitter-Moleküle abgegeben werden, so dass sie auf dem SingulettZustand des fluoreszierenden Emitters übertragen werden und hier strahlend zerfallen können.

## Patentansprüche

1. Strahlungsemittierende Vorrichtung aufweisend:
- ein Substrat (1);
- eine erste Elektrode (2) und eine zweite Elektrode (9),
- mindestens eine zwischen der ersten und zweiten Elektrode angeordnete Emitterschicht (5), die Licht im violetten oder blauen Spektralbereich emittiert, wobei die Emitterschicht ein Matrixmaterial und bezogen auf das Matrixmaterial 0,1 - 5 Gew.-% eines fluoreszierenden strahlungsemittierenden Emitters und 1-30 Gew.-% eines phosphoreszenten Exzitonenfängers umfasst, wobei das Triplettniveau des Exzitonenfängers T1_{Exzitonenfänger} höher liegt als das Singulettniveau des strahlungsemittierenden Emitters S1_{Emitter},
und
wobei das Emissionsmaximum des fluoreszierenden Emitters und das des phosphoreszenten Exzitonenfängers im blauen, violetten oder ultravioletten Spektralbereich liegen, **dadurch gekennzeichnet, dass** der phosphoreszente Exzitonenfänger und der fluoreszierende strahlungsemittierende Emitter statistisch über die Emitterschicht verteilt sind.

2. Strahlungsemittierende Vorrichtung nach dem vorhergehenden Anspruch, wobei der Exzitonenfänger ein Emissionsmaximum bei einer kürzeren Wellenlänge als der strahlungsemittierende Emitter aufweist.

3. Strahlungsemittierende Vorrichtung nach einem der vorhergehenden Ansprüche, wobei das Triplettniveau der Matrix T1_{Matrix} höher liegt als das Triplettniveau des Exzitonenfängers T1_{Exzitonenfänger}.

4. Strahlungsemittierende Vorrichtung nach einem der vorhergehenden Ansprüche, wobei die Differenz der Wellenlänge der Emissionsmaxima maximal 1-100 nm beträgt.

5. Strahlungsemittierende Vorrichtung nach einem der vorhergehenden Ansprüche, wobei die Intensität der normalisierten Emission des Emissionsmaximums des Exzitonenfängers in der Emitterschicht maximal 20%, bevorzugt maximal 10% der Intensität des Emissionsmaximums des strahlungsemittierenden Emitters beträgt.

6. Strahlungsemittierende Vorrichtung nach einem der vorhergehenden Ansprüche, aufweisend zumindest eine weitere Emitterschicht, die Licht im grünen, gelben, orangen und/oder roten Spektralbereich emittiert.

7. Strahlungsemittierende Vorrichtung nach dem vorhergehenden Anspruch, wobei durch eine Überlagerung der durch die erste Emitterschicht (5) und die zumindest eine weitere Emitterschicht emittierten Strahlung Weißlicht emittiert wird.

## Claims

1. Radiation emitting device having:
- a substrate (1);
- a first electrode (2) and a second electrode (9),
- at least one emitter layer (5) being arranged between the first and second electrodes, which emits light in the violet or blue spectral range, wherein
the emitter layer comprises a matrix material and, based on the matrix material, 0.1 - 5 wt.% of a fluorescent radiation emitting emitter and 1-30 wt.% of a phosphorescent exciton trap, wherein the triplet level of the exciton trap T1_{exciton trap} is higher than the singlet level of the radiation emitting emitter S1ₑₘᵢₜₜₑᵣ,
and
wherein the emission maximum of the fluorescent emitter and that of the phosphorescent exciton trap being in the blue, violet or ultraviolet spectral range, **characterized in that** the phosphorescent exciton trap and the fluorescent radiation emitting emitter are statistically distributed over the emitter layer.

2. Radiation emitting device according to the preceding claim, wherein the exciton trap has an emission maximum at a shorter wavelength than the radiation emitting emitter.

3. Radiation emitting device according to one of the preceding claims, wherein the triplet level of the matrix T1ₘₐₜᵣᵢₓ is higher than the triplet level of the exciton trap T1_{exciton trap}.

4. Radiation emitting device according to one of the preceding claims, wherein the difference in wavelength of the emission maxima is at most 1-100 nm.

5. Radiation emitting device according to one of the preceding claims, wherein the intensity of the normalized emission of the emission maximum of the exciton trap in the emitter layer is at most 20%, preferably at most 10%, of the intensity of the emission maximum of the radiation emitting emitter.

6. Radiation emitting device according to one of the preceding claims, comprising at least one further emitter layer emitting light in the green, yellow, orange and/or red spectral range.

7. Radiation emitting device according to the preceding claim, wherein white light is emitted by a superposition of the radiation emitted by the first emitter layer (5) and the at least one further emitter layer.

## Revendications

1. Dispositif émetteur de rayonnement comportant:
- un substrat (1);
- une première électrode (2) et une deuxième électrode (9),
- au moins une couche émettrice (5) étant disposée entre la première et la seconde électrode, qui émet de la lumière dans le domaine spectral violet ou bleu, où
la couche émettrice comprend un matériau de matrice et, sur la base du matériau de matrice, 0,1 à 5 % en poids d'un émetteur émettant de rayonnement fluorescent et 1 à 30 % en poids d'un piège à exciton phosphorescent, dans laquelle le niveau triplet du piège à exciton T1_{piège à exciton} est supérieur au niveau simple de l'émetteur émettant de rayonnement S1_{émettant},
et
dans laquelle le maximum d'émission de l'émetteur fluorescent et celui du piège à exciton phosphorescent étant dans le domaine spectral bleu, violet ou ultraviolet, **caractérisé en ce que** le piège à exciton phosphorescent et l'émetteur émettant de rayonnement fluorescent sont répartis statistiquement sur la couche émettrice.

2. Dispositif émetteur de rayonnement selon la revendication précédente, dans lequel le piège à exciton a un maximum d'émission à une longueur d'onde plus courte que l'émetteur émetteur de rayonnement.

3. Dispositif émetteur de rayonnement selon l'une des revendications précédentes, dans lequel le niveau de triplet de la matrice T1_{matrice} est supérieur au niveau de triplet du piège à exciton T1_{piège à exciton}.

4. Dispositif émetteur de rayonnement selon l'une des revendications précédentes, dans lequel la différence de longueur d'onde des maxima d'émission est d'au plus 1-100 nm.

5. Dispositif émetteur de rayonnement selon l'une des revendications précédentes, dans lequel l'intensité de l'émission normalisée du maximum d'émission du piège à exciton dans la couche émettrice est d'au plus 20%, de préférence d'au plus 10%, de l'intensité du maximum d'émission de l'émetteur émetteur de rayonnement.

6. Dispositif émetteur de rayonnement selon l'une des revendications précédentes, comprenant au moins une autre couche émettrice qui émet de la lumière dans le domaine spectral vert, jaune, orange et/ou rouge.

7. Dispositif émetteur de rayonnement selon la revendication précédente, dans lequel la lumière blanche est émise par une superposition du rayonnement émis par la première couche émettrice (5) et la au moins une autre couche émettrice.
